# EUROPÄISCHE PATENTSCHRIFT

(11) **EP 2 850 629 B1**
(45) Veröffentlichungstag und Bekanntmachung des Hinweises auf die Patenterteilung: **25.09.2019**
(21) Anmeldenummer: 13725068.4
(22) Anmeldetag: 14.05.2013
(51) Int. Cl.: H01H 23/00, H01H 23/10, H01H 51/00, H01H 23/22

(54) **ELEKTRISCHER SCHALTER**
ELECTRICAL SWITCH
COMMUTATEUR ÉLECTRIQUE

(30) Priorität: 15.05.2012 DE 102012009574
(43) Veröffentlichungstag der Anmeldung: 25.03.2015
(73) Patentinhaber: Marquardt Mechatronik GmbH, 78604 Rietheim-Weilheim (DE)
(72) Erfinder: MAIER, Andreas, 78737 Fluorn-Winzeln (DE); GEIGER, August, D-78607 Talheim (DE); HENTSCHEL, Alexander, 78655 Dunningen-Seedorf (DE); PRILL, Alexander, 78048 Villingen-Schwenningen (DE); NILL, Daniel, 78549 Spaichingen (DE)
(74) Vertreter: Otten, Roth, Dobler & Partner mbB Patentanwälte
(86) Internationale Anmeldenummer: PCT/EP2013/001405
(87) Internationale Veröffentlichungsnummer: WO 2013/170946

(56) Entgegenhaltungen:
- WO-A1-2010/069392
- DE-A1- 2 928 277
- DE-A1- 19 802 332
- JP-A- 2000 164 076
- US-A- 3 684 850
- US-A1- 2011 141 647

## Beschreibung

Die Erfindung betrifft einen elektrischen Schalter nach dem Oberbegriff des Patentanspruchs 1.

Solche elektrischen Schalter, die aus der US 3 684 850 A und der WO 2010/069392 A1 bekannt sind, dienen zum Ein- und/oder Ausschalten von elektrischen Geräten durch eine manuelle Betätigung eines Benutzers. Insbesondere werden diese Schalter beispielsweise in der Hausgeräteindustrie für Haushaltsgeräte, wie Kaffeemaschinen, Staubsauger o. dgl., für Geräte in der Unterhaltungsindustrie etc. eingesetzt. Solche Schalter können in der Art eines Wippschalters ausgestaltet sein. Eine aus der US 2011/0141647 A1 bekannte Schaltungsanordnung für Gebäudestromkreise umfasst mehrere Relais.

Ein derartiger elektrischer Schalter kann ein Gehäuse besitzen. Im Gehäuse befindet sich ein Kontaktsystem. Aus dem Gehäuse ragt ein bewegliches Betätigungsorgan zum Umschalten des Kontaktsystems zwischen zwei Schaltstellungen, nämlich einer Ausschalt-Stellung und einer Einschalt-Stellung, heraus. Der Schalter verbleibt nach dem Einschalten in der Einschalt-Stellung und ist lediglich durch erneutes manuelles Betätigen des Betätigungsorgans ausschaltbar.

Aus der DE 198 02 332 A1 und der JP 2000 164076 A ist ein elektrischer Schalter bekannt, bei dem der Schalter zusätzlich nichtmanuell von der einen Schaltstellung in die andere Schaltstellung schaltbar ist. Hierzu ist ein ansteuerbarer Aktor vorgesehen, der mit dem Betätigungsorgan in Wirkverbindung steht. Dadurch wird das Betätigungsorgan in wenigstens einer der beiden Schaltstellungen bei Ansteuerung des Aktors zum Schalten des Kontaktsystems in die andere Schaltstellung bewegt.

Bei dem Aktor dieses Schalters handelt es sich um einen eine Spule sowie einen Anker aufweisenden Elektromagneten. Die Wirkverbindung zwischen dem Aktor und dem Betätigungsorgan wird mittels des Ankers bewirkt, wobei der Anker seinerseits mit einem Permanentmagneten in Verbindung steht. Am Betätigungsorgan ist ein metallisches Teil angeordnet, das in der Einschalt-Stellung am Anker mit der Haftkraft des Permanentmagneten anliegt. Durch Anlegen eines elektrischen Stroms an die Spule wird die Haftkraft des Permanentmagneten überwunden und das Kontaktsystem schaltet aufgrund der Kraft einer Feder in die Ausschalt-Stellung.

Der Erfindung liegt die Aufgabe zugrunde, den Schalter derart weiterzuentwickeln, dass für diesen eine besonders kompakte Ausgestaltung resultiert. Insbesondere soll ein solcher Wippschalter sowohl mechanisch, also manuell vom Benutzer, als auch elektrisch / elektronisch, also ohne manuelle Einwirkung, umschaltbar sein. Weiterhin soll die Elektronik des erfindungsgemäßen Schalters eine verbesserte Testfähigkeit und/oder Programmierbarkeit aufweisen.

Diese Aufgabe wird bei einem gattungsgemäßen elektrischen Schalter durch die kennzeichnenden Merkmale des Anspruchs 1 gelöst.

Beim erfindungsgemäßen elektrischen Schalter wird das Betätigungsorgan vom Aktor in die andere Schaltstellung bewegt. In einfacher Art und Weise wirkt der Anker mittels eines Stößels auf das Betätigungsorgan, und zwar auf einen Ansatz am Betätigungsorgan, ein. Insbesondere wird das Betätigungsorgan vom Aktor von der Einschalt- in die Ausschalt-Stellung des Kontaktsystems bewegt. Der Schalter ist somit "elektrisch / elektronisch" zumindest ausschaltbar. Weitere Ausgestaltungen der Erfindung sind Gegenstand der Unteransprüche.

Zum Schutz des Schalters vor schädlichen Einflüssen kann der Schalter zweckmäßigerweise ein Gehäuse aufweisen. Das Kontaktsystem ist im Gehäuse befindlich. Das Betätigungsorgan ragt für den Benutzer zugänglich aus dem Gehäuse. Zweckmäßigerweise ist der Aktor im Gehäuse befindlich. Um ein Elektrogerät nach einer gewissen Zeit, beispielsweise in der sich das Elektrogerät im Standby-Modus befindet, automatisch ausschalten zu können, kann der Schalter eine programmierbare Elektronik, die insbesondere einen Timer umfasst, zur gesteuerten Bewegung des Betätigungsorgans in die andere Schaltstellung des Kontaktsystems aufweisen. Zweckmäßigerweise ist die Elektronik auf einer im Gehäuse befindlichen Leiterplatte angeordnet. Beispielsweise kann dann im Standby-Betrieb der Timer in Gang gesetzt werden, um eine Kaffeemaschine nach einer bestimmten Zeit auszuschalten. In besonders flexibler Art weist die Elektronik hierzu einen Mikrocontroller auf, wobei eine Zeitspanne, insbesondere in der Art einer Abschaltzeit, programmierbar ist. Die Elektronik steuert bei Ablauf der Zeitspanne den Aktor zum

Schalten des Kontaktsystems an, also beispielsweise wird nach dem vorprogrammierten Zeitablauf die Kaffeemaschine automatisch ausgeschaltet.

Mit Hilfe des erfindungsgemäßen Schalters kann ein Elektrogerät nach einer definierten Zeit automatisch ausgeschaltet werden. Dadurch wird Energie, insbesondere solche für den Standby-Betrieb des Elektrogeräts eingespart. Der erfindungsgemäße Schalter realisiert damit vorteilhafterweise einen "ECO"-Schalter zur Energieeinsparung.

Zwecks Prüfung der Funktion des Schalters kann in einer weiteren Ausgestaltung die Elektronik in einem Testmodus für die Ansteuerung des Aktors betreibbar sein. Hierzu kann die Netzfrequenz der Versorgungsspannung als Indikator zum Wechsel in den Testmodus verwendet werden. Beispielsweise wechselt die Elektronik in den Testmodus, wenn eine Netzfrequenz erkannt wird, die nicht den netzüblichen Frequenzen von 50 Hz beziehungsweise 60 Hz entspricht sowie einen definierten Wert aufweist. Wenn die Elektronik anschließend eine netzübliche Frequenz erkennt, wird dann die Aktion für den Testmodus aktiviert. Bei dieser Aktion wird der Schalter insbesondere vor Ablauf der Zeitspanne umgeschaltet, beispielsweise wird der Schalter sofort ausgeschaltet, womit die Funktionsfähigkeit des Schalters ohne Abwarten der Abschaltzeit festgestellt werden kann.

Für eine besonders bevorzugte Ausgestaltung eines solchen Schalters, bei dem die Verwendung einer bestimmten Netzfrequenz der Versorgungsspannung als Indikator zum Wechsel in den Testmodus erfolgt, ist nachfolgendes festzustellen.

### Aufgabe:

Im zusammengebauten Zustand kann ein auf eine bestimmte Abschaltzeit programmierter Schalter nicht vorzeitig automatisch ausgeschaltet werden. Zur Absicherung der Funktionalität müsste die vordefinierte Zeit abgewartet werden. Zur Verkürzung der Wartezeit kann ein Testmodus implementiert werden, der sich durch Vorgabe eines eindeutigen Signals aktivieren lässt.

### Lösung:

Allgemein wird die Netzfrequenz der Versorgungsspannung als Indikator zum Wechsel in den Testmodus verwendet. Damit durch das Betreiben der Anwendung bei der Indikatorfrequenz keine Nachteile entstehen, wird die Aktion erst nach dem Verlassen der Indikatorfrequenz gestartet.

Beim gegebenen Fall wird nach jedem Hardware-Reset die Frequenz der Netzspannung bewertet. Die Messung geschieht durch einen Phasendetektor. Wird eine Netzfrequenz erkannt, die nicht den netzüblichen Frequenzen (50 Hz bzw. 60 Hz) entspricht und einen definierten Wert aufweist, wechselt die Elektronik in den Testmodus. In dem Augenblick, in dem der Mikrokontroller wieder eine netzübliche Frequenz erkennt, wird die Aktion des Testmodus aktiviert, d.h. der Schalter wird sofort ausgeschaltet.

### Fortschritt, Vorteile:

- Eine Kontaktierung der Elektronik zur Realisierung eines eindeutigen Indikators entfällt.
- Es ist mit einem gewissen Aufwand verbunden, den Indikator zu realisieren. Gleichzeitig macht dieser Umstand den Indikator sehr eindeutig und die damit ausgerüstete Anwendung sicher.
- Es ist keine zusätzliche Schnittstelle notwendig. Dadurch sehr günstig in der Realisierung von Anwendungen großer Losgrößen.
- Der Kunde kann den Schalter an der Montagelinie, und zwar im Montagetakt, im Endgerät prüfen.

In einer weiteren Ausgestaltung kann nach der Montage zunächst der Testmodus am Schalter eingestellt sein. Hierfür kann die Leiterplatte eine Lasche aufweisen, durch die Elektronik in einer zunächst vorgesehenen Betriebsart, und zwar insbesondere im Testmodus, betrieben wird. Ist dann die Funktionsfähigkeit des Schalters positiv getestet, so kann durch wenigstens teilweises Entfernen der Lasche die Elektronik in einer anderen Betriebsart betrieben werden. Insbesondere wird dann der Testmodus beendet und der Schalter in seiner üblich, vorgesehenen Betriebsart betrieben. Zwecks einfacher Entfernung der Lasche kann diese durch einen Schlitz im Gehäuse nach außen geführt sein. Es kann sich dann anbieten, dass nach Entfernen des aus dem Gehäuseschlitz herausragenden Teils der Lasche, was beispielsweise durch Abbrechen am Gehäuseschlitz vorgenommen werden kann, die restliche Lasche als Verschluss für den Gehäuseschlitz dient. Damit ist sichergestellt, dass ein Eindringen von schädlichen äußeren Einflüssen in das Gehäuse wirksam verhindert ist.

Zur einfachen Programmierung der Abschaltzeit in den elektrischen Schalter kann in einer weiteren Ausgestaltung die Leiterplatte eine Programmierlasche aufweisen. Die Programmierlasche ist zweckmäßigerweise durch einen Schlitz im Gehäuse nach außen geführt. Dadurch ist mittels Kontaktierungspunkten an der Programmierlasche das Programmieren und/oder die Endkontrolle des Schalters ermöglicht. Die Programmierlasche kann am Gehäuseaustritt perforiert sein, so dass diese nach der Fertigstellung in einfacher Weise abgebrochen werden kann. Die restliche, verbleibende Programmierlasche kann als Verschluss für den Gehäuseschlitz dienen, womit ein Eintritt von Schadstoffen in das Gehäuse verhindert ist.

Für eine besonders bevorzugte Ausgestaltung eines solchen Elektronikschalters mit einer Programmierlasche ist nachfolgendes festzustellen.

### Aufgabe:

Die Auto-off-Schalter (AOS) erhalten je nach Kundenwunsch verschiedene Ausschaltzeiten. Die Zeit sollte aufgrund eines optimierten Fertigungsprozesses erst am fertigen Produkt aufgespielt werden. Zudem ist eine Kontaktierung der Leiterplatte bei der Endkontrolle (EOLT) erforderlich. Zu beachten ist bei der Lösungsfindung auch die Schutzklasse des Schalters.

### Lösung:

Die Leiterplatte erhält eine Programmierlasche, die durch einen Schlitz im Gehäuse nach außen geführt wird. Auf der Lasche befinden sich die erforderlichen Kontaktierungspunkte für das Programmieren und die Endkontrolle. Die Lasche ist am Gehäuseaustritt perforiert, so dass diese nach der Fertigstellung als "Gutkennzeichnung" abgebrochen werden kann. Die Rest-Lasche dient dabei als Verschluss für den Gehäuseschlitz, d.h. die Schutzklasse kann ohne ein Zusatzteil eingehalten werden.

### Fortschritt, Vorteile:

Die erfindungsgemäßen Schalter können "neutral" an der Montagelinie aufgebaut werden. Die kundenspezifische Zuordnung (Variantenbildung) erfolgt erst beim letzten Arbeitsgang, nämlich dem Programmieren.

Es kann sich in einer weiteren Ausgestaltung anbieten, dass der Aktor bei fehlerhaftem Nichterfolgen des Umschaltens des Kontaktsystems in die andere Schaltstellung wenigstens ein weiteres Mal angesteuert wird. Zwischen den Ansteuerimpulsen für den Aktor kann dabei eine an das Abkühlverhalten des Aktors angepasste Zeit gewartet werden, bevor wieder der Steuerimpuls für die nächste Ansteuerung ausgelöst wird. Nach einer definierten Anzahl an fehlerhaften Ansteuerversuchen kann jedoch zweckmäßigerweise die Funktion des ansteuerbaren Umschaltens deaktiviert werden.

Für eine besonders bevorzugte Ausgestaltung eines solchen Schalters, der eine Abschaltsicherung bei klemmender Wippe besitzt, ist nachfolgendes festzustellen.

### Aufgabe:

Die automatische Abschaltung des Schalters erfolgt durch einen Anker, der wiederum durch einen Elektromagneten angetrieben wird. Bedingt durch die technische Auslegung ist die Ausschaltkraft begrenzt. Das bedeutet, wenn die Wippe am Ausschalten gehindert wird, so bleibt der Schalter eingeschaltet und würde unter gewissen Umständen das Produkt dadurch beschädigen, nämlich die Spule brennt durch.

### Lösung:

Bei fehlgeschlagener automatischer Ausschaltung wird der Schalter ein wiederholtes Mal angesteuert. Zwischen den Ansteuerimpulsen wird eine an das Abkühlverhalten der Spule angepasste Zeit gewartet, bevor wieder ein Steuerimpuls ausgelöst wird. Sollte nach der definierten Anzahl an "Ausschaltversuchen" der Schalter immer noch eingeschaltet sein, so wird die Auto-off-Funktion deaktiviert. Der Schalter muss danach manuell in die AUS-Stellung gebracht werden.

### Fortschritt, Vorteile:

- Gewährleistung größtmöglicher Funktionalität bei gleichzeitiger funktionaler Sicherheit.
- Der Kunde kann den Schalter bei einer nicht funktionierenden Abschaltung als "normalen" Ein-Aus-Schalter nutzen.

In einer weiteren Ausgestaltung ist der Lastkreis des Schalters vom Ansteuerkreis des Aktors getrennt. Dabei kann der Ansteuerkreis mittels Niedervolt betrieben werden. Zur Trennung kann ein Opto-Koppler verwendet werden.

Für eine besonders bevorzugte Ausgestaltung eines solchen Schalters, der eine Niedervoltvariante im Schalterprogramm realisiert, ist nachfolgendes festzustellen.

### Aufgabe:

Trennung von Last- und Ansteuerkreis beim Auto-off-Schalter (AOS). Die kundenseitige Ansteuerung des Schalters soll mit Niedervolt erfolgen. Die Außenabmessungen der Schalterfamilie sollen dadurch nicht negativ beeinflusst werden.

### Lösung:

Durch den Einsatz eines Opto-Kopplers wird die Trennung erreicht. Die Aufteilung der Leiterplatte und Platzierung des Bauteiles sowie die Anschlussführung nach außen ermöglicht die Unterbringung der Schaltung im definierten Einbauvolumen.

### Fortschritt, Vorteile:

Der Kunde kann die Maschine beim Einsatz der Niedervoltvariante kostengünstiger bauen beziehungsweise auslegen. Es ist z.B. kein Schutzkontakt am Netzstecker erforderlich.

Bei einer weiteren Ausgestaltung weist die Elektronik eine Sicherung für den Überlastungs- und/oder Fehlerfall auf. In einfacher Art und Weise kann die Sicherung als eine Sicherungsstrecke, und zwar falls gewünscht direkt im Leiterplattenlayout der Leiterplatte, integriert sein. Die Sicherungsstrecke kann in der Ebene und/oder räumlich über die Leiterplatten-Dicke in der Leiterplatte geführt sein.

Für eine besonders bevorzugte Ausgestaltung eines solchen Schalters mit einer Sicherungsstrecke ist nachfolgendes festzustellen.

### Aufgabe:

Im Überlastungs- und/oder Fehlerfall, beispielsweise ein Transistor legiert durch, muss ein Brand, verursacht durch die Elektronik, ausgeschlossen werden. Aufgrund des Preisdruckes sollten bzw. dürfen keine Mehrkosten entstehen.

### Lösung:

Im Leiterplattenlayout wird eine Sicherungsstrecke integriert. Zur Realisierung der Ansprechzeiten unter Berücksichtigung des Grenzstromes wird die Strecke nicht nur in der Ebene sondern auch räumlich, also in der Leiterplatten-Dicke, geführt. Unter Ausnutzung von Konturen, Querschnitten und/oder Zusatzbohrungen wird ein Temperaturgefälle erzeugt, das mechanische Spannungen in der Sicherungsstrecke zur Folge hat und diese bei Überlastung abreißt. Vorteil bei Verwendung der Durchkontaktierung ist, dass die Schicht prozesstechnisch dünner ausgeführt werden kann und sich die Erwärmung im "Durchsteiger" schneller einstellt.

### Fortschritt, Vorteile:

Produktsicherheit ohne Mehrkosten.

Bei einer weiteren Ausgestaltung ist ein Mittel zur Messung des durch den Schalter fließenden elektrischen Stroms vorgesehen. Das Mittel zur Strommessung kann einen Widerstand, der insbesondere wiederum aus einer mäanderförmigen Bahn an einem elektrischen Anschluss des Schalters besteht, umfassen. Falls benötigt kann das Mittel zur Strommessung weiter einen Verstärker sowie gegebenenfalls einen Komparator umfassen. Für eine besonders bevorzugte Ausgestaltung eines solchen Schalters, bei dem die Messung eines Wechselstroms unter Zuhilfenahme eines Komparators ermöglicht ist, ist nachfolgendes festzustellen.

### Aufgabe:

Ein Merkmal des AOS+I-Schalterfamilie (Auto-off-Schalter mit Stromerkennung) ist die eigenständige Erkennung der Arbeitsmodi und dem Kundenwunsch entsprechenden Reaktionen darauf. Die Erkennung der Arbeitsmodi erfolgt durch das Einlesen und der Interpretation des Arbeitsstroms. Der Stromfluss hat einen kleinen Spannungsabfall am Mäanderwiderstand, das als ein Stanzteil ausgebildet sein kann, zur Folge. Der Widerstandswert des Mäanders kann aufgrund einer gleichzeitigen Erhöhung der Erwärmung nicht vergrößert werden. Daher stellt sich folgende Aufgabe:
1. Es wird ein hoch verstärkender Verstärker benötigt der auch bei stark schwankenden Umwelteinflüssen ein stabiles Ausgangsignal liefert.
2. Es wird ein kostengünstiger und Strom sparender AD-Wandler benötigt, der auch bei kleinen Amplituden eine hohe Auflösung hat.

### Lösung:

Die Lösung mittels Hardware erfolgt durch den Einsatz eines Stromspiegels, der zwei Ausgänge mit unterschiedlichen Eigenschaften besitzt, und zwar
1. einen stromunabhängigen Referenzausgang (K1) sowie
2. einen Transimpedanzverstärker, der aus einem Mäander und einem Verstärker aufgebaut ist (K2).

Durch den symmetrischen Aufbau der beiden Ausgänge werden Umweltstörgrößen, z.B. Temperatureinflüsse, kompensiert. Ein Stromfluss durch den Mäanderwiderstand bewirkt ab einer gewissen Stromamplitude ein periodisches Kreuzen des Signals K2 mit dem Referenzsignal K1. Beide Signale werden einem Komparator zugeführt, der bei jedem Kreuzen der Signale seinen Ausgangswert ändert. Das Ergebnis ist ein PWM(Puls-Weiten-Modulations)-Signal.

Die Lösung mittels Software berücksichtigt nachfolgendes. Ist die Kurvenform des Stroms bekannt, und zwar in der Regel ein Sinussignal, so lässt sich die Stromamplitude aus dem Tastverhältnis λ des PWM-Signals eindeutig bestimmen. In der Software kann entweder direkt die mathematische Beziehung hinterlegt werden oder mittels einer Zuordnungstabelle auf die Stromamplitude zurückgeschlossen werden.

Fortschritt, Vorteile:
1. Echte und genaue Strommessung beim Kennen der Stromform ermöglicht.
2. Robust gegen Umweltstörgrößen.
3. Verzicht auf einen AD-Wandler und damit eine Verkleinerung der Strombedarfs. Das ist insbesondere bei Einsatz von resistiven Netzteilen zwingend erforderlich.
4. Kostengünstige Realisierung einer genauen Strommessung.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: einen elektrischen Schalter in Seiten-, Front- und Unteransicht,
- Fig. 2: diverse Schnitte durch den elektrischen Schalter aus Fig. 1,
- Fig. 3: den Schalter aus Fig. 1 mit geöffnetem Gehäuse, wobei sich der Schalter in der Einschalt-Stellung befindet,
- Fig. 4: den Schalter wie in Fig. 3, wobei sich der Schalter in einer Zwischenposition während des Ausschalt-Vorganges befindet,
- Fig. 5: den Schalter wie in Fig. 3, wobei sich der Schalter in der Ausschalt-Stellung befindet,
- Fig. 6: ein Schaltbild für den Anschluss des elektrischen Schalters,
- Fig. 7: der Funktionsablauf für den Schalter gemäß einer weiteren Ausführung,
- Fig. 8: diverse Ansichten des Schalters gemäß einer noch weiteren Ausführung,
- Fig. 9: der Funktionsablauf für den Schalter gemäß einer nochmals weiteren Ausführung,
- Fig. 10: diverse Ansichten des Schalters mit Schaltbild gemäß einer abermals weiteren Ausführung und
- Fig. 11: das Schaltbild sowie den Funktionsablauf für den Schalter gemäß einer wiederum weiteren Ausführung.

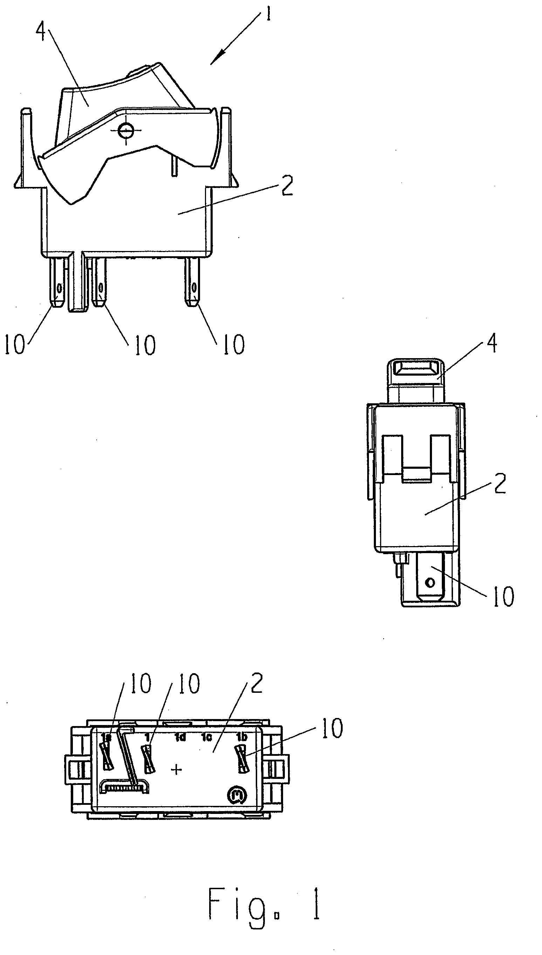

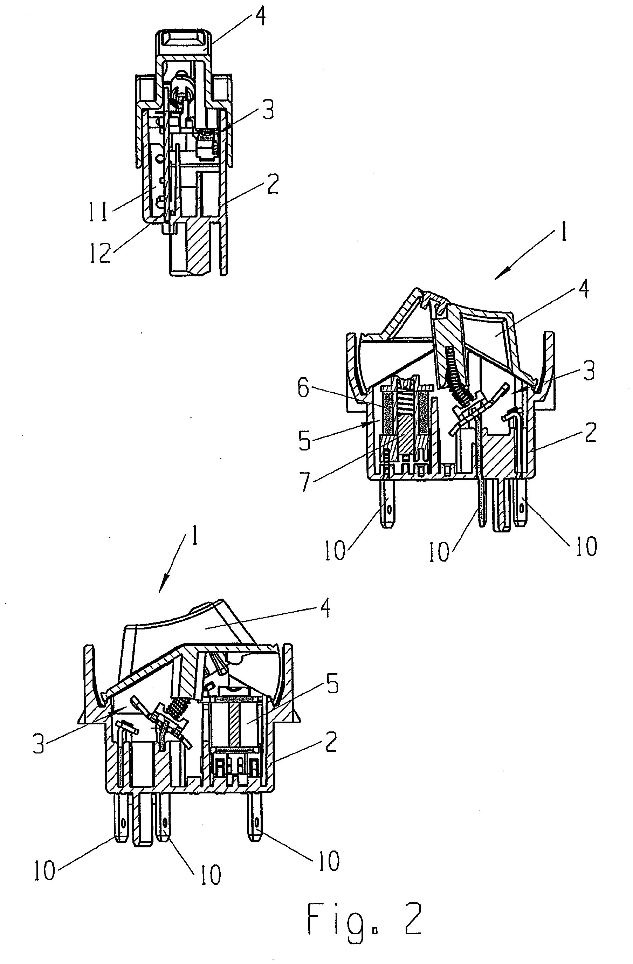

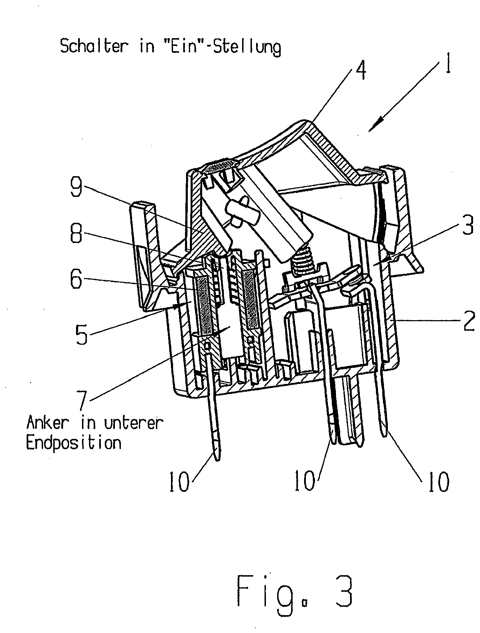

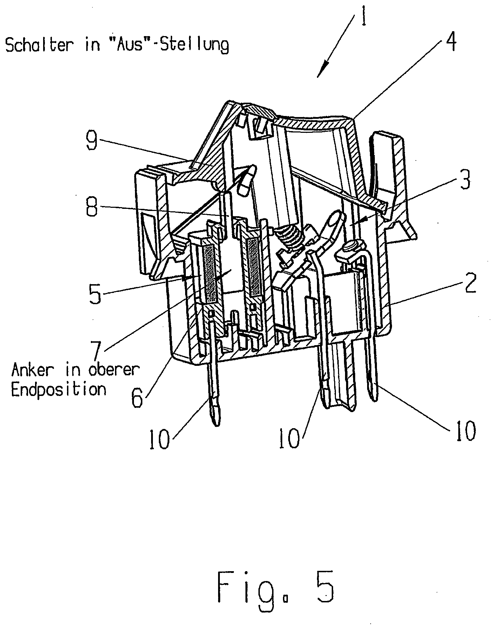

In Fig. 1 ist ein elektrischer Schalter 1 zu sehen, der als ein Wippschalter ausgebildet ist. Der Schalter 1 besitzt ein Gehäuse 2. Im Inneren des Gehäuses 2 befindet sich ein Kontaktsystem 3, wie in Fig. 2 zu erkennen ist. Zur Zuführung der elektrischen Spannung zum Kontaktsystem 3 ragen aus dem Gehäuse 2 elektrische Anschlüsse 10 heraus. Der Schalter 1 besitzt weiter ein bewegliches Betätigungsorgan 4, das vorliegend als Wippe ausgestaltet ist, zum manuellen Umschalten des Kontaktsystems 3 zwischen zwei Schaltstellungen, nämlich einer in Fig. 3 gezeigten Einschalt-Stellung sowie einer in Fig. 5 gezeigten Ausschalt-Stellung. Schließlich befindet sich noch ein ansteuerbarer Aktor 5 im Gehäuse 2, der gemäß Fig. 3 mit dem Betätigungsorgan 4 in Wirkverbindung steht, derart dass das Betätigungsorgan 4 in wenigstens einer der beiden Schaltstellungen bei Ansteuerung des Aktors 5 vom Aktor 5 zum Schalten des. Kontaktsystems 3 in die andere Schaltstellung bewegt wird. Insbesondere handelt es sich bei dem Schalter 1 um einen selbstabschaltbaren Schalter, so dass das Betätigungsorgan 4 vom Aktor 5 von der Einschalt- in die Ausschalt-Stellung des Kontaktsystems 3 bewegt wird.

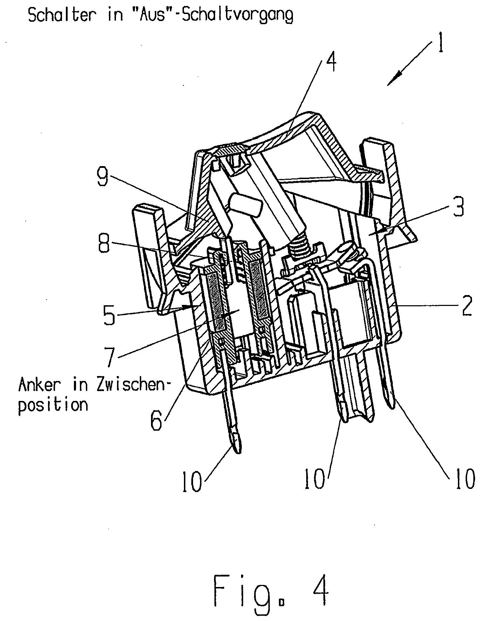

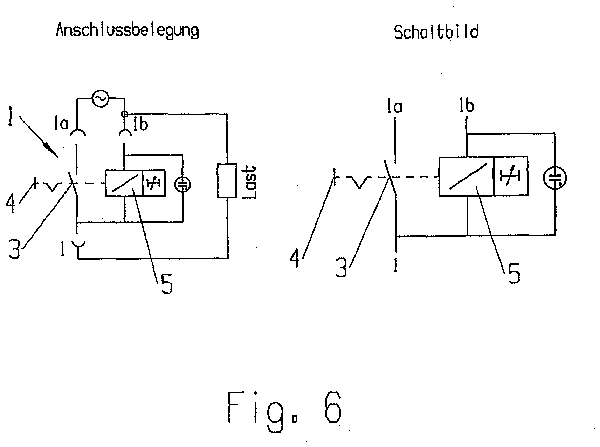

Wie anhand der Fig. 2 zu erkennen ist, handelt es sich bei dem Aktor 5 um einen eine Spule 6 sowie einen Anker 7 aufweisenden Elektromagneten. Die Wirkverbindung zwischen dem Aktor 5 und dem Betätigungsorgan 4 wird mittels des Ankers 7 bewirkt. Hierzu wirkt der Anker 7 mittels eines Stößels 8 auf einen Ansatz 9 am Betätigungsorgan 4 ein, wie dem Ausschaltvorgang beim Selbstabschalten gemäß der Fig. 3 bis Fig. 5 zu entnehmen ist. Das Schaltbild mitsamt Anschlussbelegung für den den Aktor 5 aufweisenden selbstabschaltenden Schalter 1 ist näher in Fig. 6 zu sehen.

Der Schalter 1 weist eine programmierbarer Elektronik 11 auf, wie in Fig. 2 zu sehen ist. Die Elektronik 11 ist auf einer im Gehäuse 2 befindlichen Leiterplatte 12 angeordnet. Die Elektronik 11 umfasst einen Timer zur gesteuerten Bewegung des Betätigungsorgans 4 in die andere Schaltstellung des Kontaktsystems 3. Hierzu weist die Elektronik 11 einen Mikrocontroller auf, wobei eine Zeitspanne in der Art einer Abschaltzeit in den Mikrocontroller programmierbar ist, derart dass die Elektronik 11 bei Ablauf der Zeitspanne den Aktor 5 zum Schalten des Kontaktsystems 3 ansteuert.

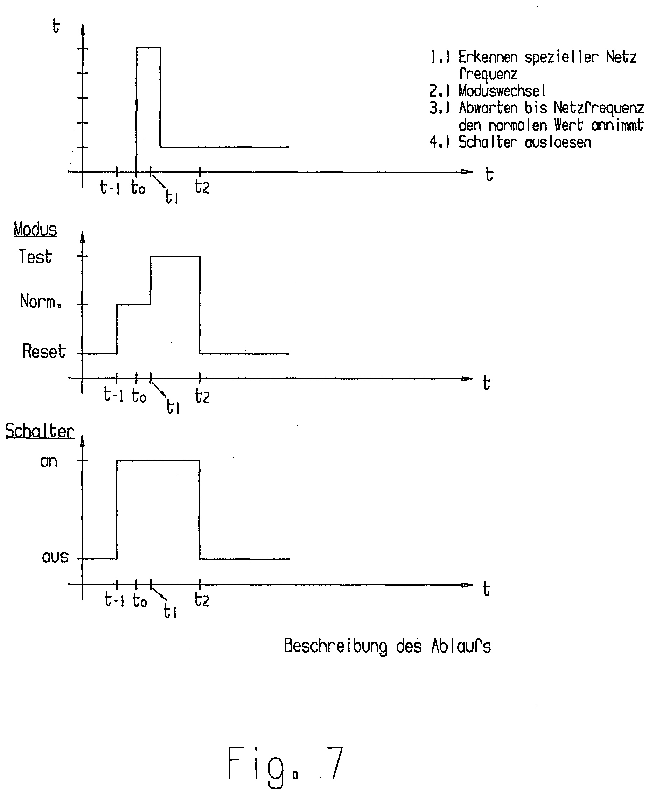

Gemäß einer Ausführung des Schalters 1 ist die Elektronik 11 in einem Testmodus für die Ansteuerung des Aktors 5 betreibbar, um so die Funktionsfähigkeit der Selbstabschaltung des Schalters 1 ohne Zeitverzögerung testen zu können. Hierfür wird die Netzfrequenz der Versorgungsspannung als Indikator zum Wechsel in den Testmodus verwendet, wie in Fig. 7 gezeigt ist. Wird eine Netzfrequenz erkannt, die nicht den netzüblichen Frequenzen, also 50 Hz bzw. 60 Hz, entspricht sowie einen definierten Wert aufweist, so wechselt die Elektronik 11 in den Testmodus. Wenn die Elektronik 11 anschließend eine netzübliche Frequenz erkennt, wird die Aktion des Testmodus aktiviert, bevorzugterweise wird bei dieser Aktion der Schalter 1 mittels Ansteuerung des Aktors 5 sofort ausgeschaltet.

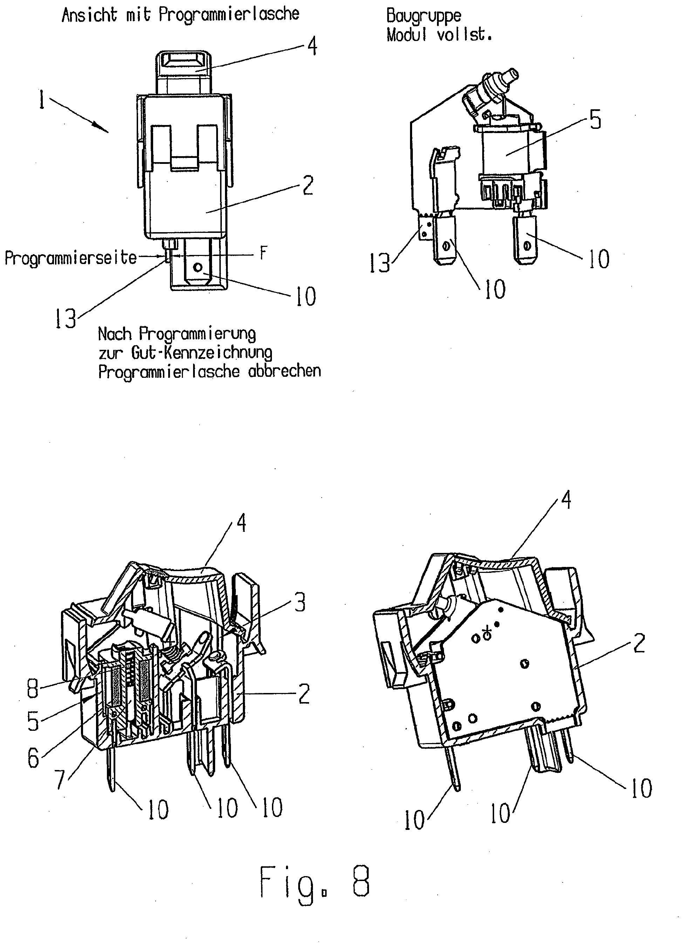

Gemäß einer weiteren Ausführung des Schalters 1, die in Fig. 8 gezeigt ist, weist die Leiterplatte 12 eine Programmierlasche 13 auf. Die Programmierlasche 13 ist durch einen Schlitz im Gehäuse 2 nach außen geführt, derart dass mittels Kontaktierungspunkten an der Programmierlasche 13 das Programmieren und/oder die Endkontrolle des Schalters 1 bei dessen Herstellung ermöglicht ist. Die Programmierlasche 13 ist am Gehäuseaustritt perforiert, derart dass diese nach der Fertigstellung abgebrochen werden kann. Dabei dient dann die restliche, im Schlitz befindliche Programmierlasche 13 als Verschluss für den Gehäuseschlitz. Anstelle einer Programmierlasche kann auch lediglich eine einfache Lasche 13 Verwendung finden, die bei Vorhandensein den Schalter 1 im Testmodus betreibt sowie bei Nichtvorhandensein den Schalter 1 den Testmodus beendet und den Schalter 1 in dessen "üblicher" Betriebsart betreibt. Das Entfernen des aus dem Gehäuseschlitz herausragenden Teils der Lasche 13 kann beispielsweise durch Abbrechen erfolgen, so dass der verbleibende Teil der Lasche 13 den Gehäuseschlitz verschließt.

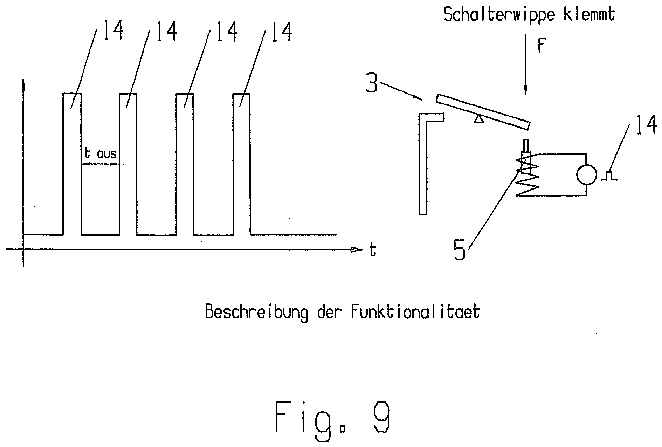

Bei fehlerhaftem Nichterfolgen des Umschaltens des Kontaktsystems 3 in die andere Schaltstellung, was beispielsweise bei einem klemmenden Betätigungsorgan 4 auftreten kann, wird der Aktor 5 wenigstens ein weiteres Mal angesteuert. Um jedoch eine Überlastung des Aktors 5 zu vermeiden, wird zwischen den Ansteuerimpulsen 14 für den Aktor 5 eine an das Abkühlverhalten des Aktors 5 angepasste Zeit gewartet, bevor wieder der Steuerimpuls 14 für die nächste Ansteuerung ausgelöst wird, wie in Fig. 9 zu sehen ist. Nach einer vorab definierten Anzahl an fehlerhaften Ansteuerversuchen wird die Funktion des ansteuerbaren Umschaltens deaktiviert. In diesem Fall ist dann der Schalter 1 lediglich manuell durch Bewegen des Betätigungsorgans 4 vom Benutzer abschaltbar.

Wie aus der Fig. 6 hervorgeht, wird der Lastkreis für den Schalter 1 sowie der Ansteuerkreis für den Aktor 5 mit derselben Spannung betrieben. In einer weiteren Ausführung, die allerdings nicht näher dargestellt ist, wird der Lastkreis des Schalters 1 vom Ansteuerkreis des Aktors 5 getrennt. Dadurch kann dann der Ansteuerkreis mittels Niedervolt betrieben werden. Zur Trennung des Last- und Ansteuerkreises kann ein Opto-Koppler verwendet werden.

In einer weiteren Ausführung, die ebenfalls nicht näher dargestellt ist, kann die Elektronik 11 mit einer Sicherung für den Überlastungs- und/oder Fehlerfall versehen sein. Die Sicherung ist als eine Sicherungsstrecke im Layout der Leiterplatte 12 integriert. Hierzu ist die Sicherungsstrecke in der Ebene der Leiterplatte 12 und/oder räumlich in der Leiterplatte 12 unter Ausnutzung der Leiterplatten-Dicke geführt.

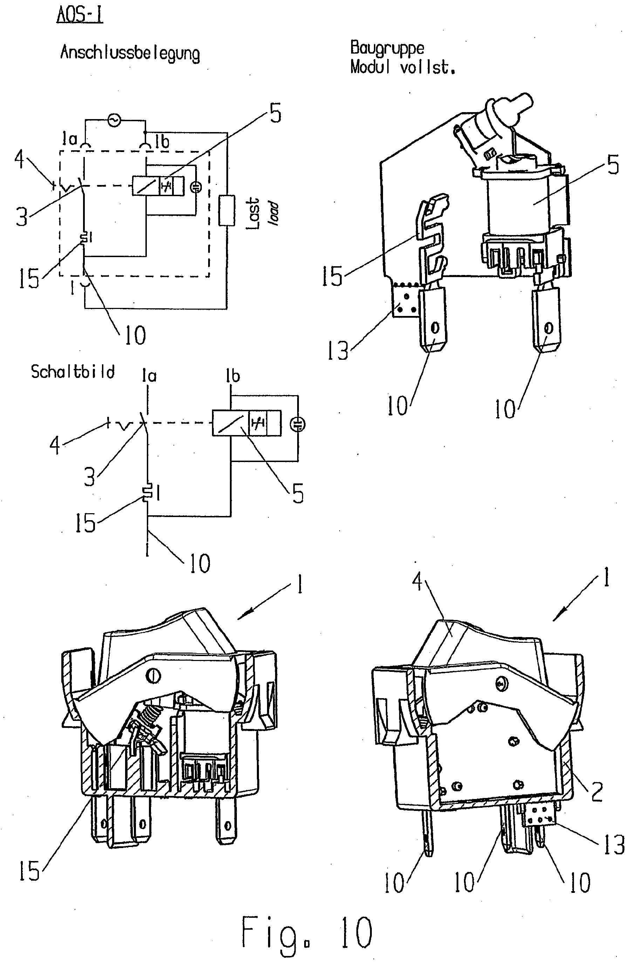

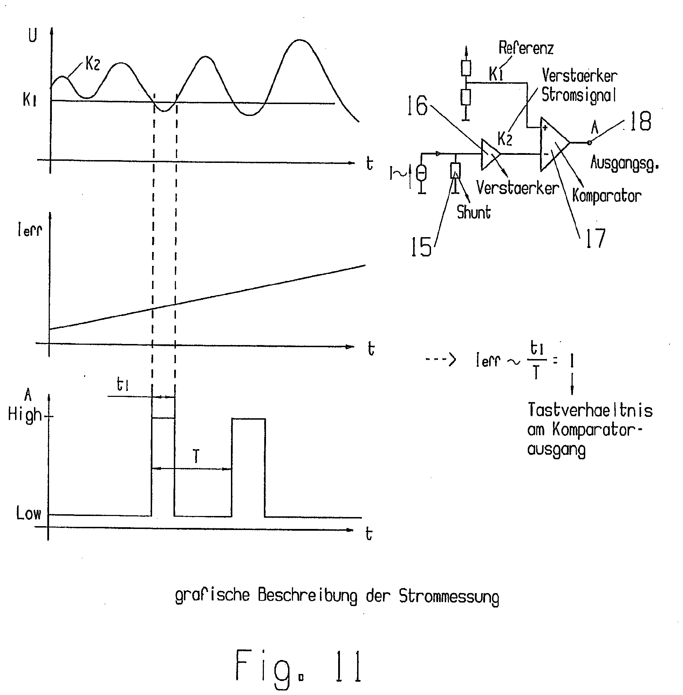

Bei einer weiteren Ausführung, die in Fig. 10 und Fig. 11 gezeigt ist, ist ein Mittel zur Messung des durch den Schalter 1 fließenden elektrischen Stroms vorgesehen. Dieses Mittel zur Strommessung umfasst einen Widerstand 15, einen Verstärker 16 sowie einen Komparator 17. Der Widerstand 15 ist gemäß Fig. 10 als eine mäanderförmige Bahn an dem einen elektrischen Anschluss 10 ausgebildet. Wie weiter aus Fig. 11 hervorgeht, wird die Größe des gemessenen Stroms als Tastverhältnis in der Art eines Puls-Weiten-Signals am Ausgang 18 des Komparators 17 ausgegeben.

Die Erfindung ist nicht auf die beschriebenen und dargestellten Ausführungsbeispiele beschränkt. Sie umfasst vielmehr auch alle fachmännischen Weiterbildungen im Rahmen der durch die Patentansprüche definierten Erfindung. So kann ein derartiger elektrischer Schalter 1 nicht nur für Kaffeemaschinen sondern auch in sonstigen Elektrogeräten, bei denen ein automatisches Um- und/oder Ausschalten ermöglicht sein soll, sowie bei sonstigen Hausgeräten, Gartengeräten, Elektrowerkzeugen o. dgl. Verwendung finden.

### Bezugszeichen-Liste:

- 1:: (elektrischer) Schalter
- 2:: Gehäuse
- 3:: Kontaktsystem
- 4:: Betätigungsorgan
- 5:: Aktor
- 6:: Spule
- 7:: Anker
- 8:: Stößel
- 9:: Ansatz (am Betätigungsorgan)
- 10:: (elektrischer) Anschluss
- 11:: Elektronik
- 12:: Leiterplatte
- 13:: Programmierlasche / Lasche
- 14:: Ansteuerimpuls / Steuerimpuls
- 15:: Widerstand
- 16:: Verstärker
- 17:: Komparator
- 18:: Ausgang (von Komparator)

## Patentansprüche

1. Elektrischer Schalter mit einem Kontaktsystem (3) sowie mit einem beweglichen Betätigungsorgan (4) zum Umschalten des Kontaktsystems (3) zwischen zwei Schaltstellungen und mit einem ansteuerbaren Aktor (5), der mit dem Betätigungsorgan (4) in Wirkverbindung steht, derart dass das Betätigungsorgan (4) in wenigstens einer der beiden Schaltstellungen bei Ansteuerung des Aktors (5) zum Schalten des Kontaktsystems (3) in die andere Schaltstellung bewegt wird, wobei es sich bei dem Aktor (5) um einen eine Spule (6) sowie einen Anker (7) aufweisenden Elektromagneten handelt, und wobei die Wirkverbindung zwischen dem Aktor (5) und dem Betätigungsorgan (4) mittels des Ankers (7) bewirkt wird, wobei das Betätigungsorgan (4) vom Aktor (5) in die andere Schaltstellung bewegt wird, indem der Anker (7) mittels eines Stößels (8) auf einen Ansatz (9) am Betätigungsorgan (4) einwirkt,
wobei, der Schalter (1) ein Gehäuse (2) besitzt, **dadurch gekennzeichnet dass** der Schalter (1) eine im Gehäuse (2) befindliche Leiterplatte (12) aufweist, auf der sich eine programmierbare Elektronik (11) zur gesteuerten Bewegung des Betätigungsorgans(4) in die andere Schaltstellung des Kontaktsystems (3) befindet, und dass die Leiterplatte (12) eine Lasche (13) aufweist, durch die die Elektronik (11) in einer Betriebsart betrieben wird, wobei durch wenigstens teilweises Entfernen der Lasche (13) die Elektronik (11) in einer anderen Betriebsart betrieben wird, wobei es sich bei der einen Betriebsart um einen Testmodus zur Überprüfung für die Ansteuerung des Aktors (5) handelt und in der anderen Betriebsart der Testmodus beendet wird.
und/oder
die Leiterplatte (12) eine Programmierlasche (13) aufweist, derart dass mittels Kontaktierungspunkten an der Programmierlasche (13) das Programmieren und/oder die Endkontrolle des Schalters (1) ermöglicht ist.

2. Elektrischer Schalter nach Anspruch 1, **dadurch gekennzeichnet, dass** es sich bei den Schaltstellungen um eine Einschalt- sowie eine Ausschalt-Stellung handelt, und dass das Betätigungsorgan (4) vom Aktor (5) von der Einschalt- in die Ausschalt-Stellung des Kontaktsystems (3) bewegt wird.

3. Elektrischer Schalter nach Anspruch 1 oder 2, **dadurch gekennzeichnet, dass** dass der Aktor (5) im Gehäuse (2) befindlich ist.

4. Elektrischer Schalter nach Anspruch 1, 2 oder 3, **dadurch gekennzeichnet, dass** die programmierbare Elektronik (11)einen Timer umfasst.,

5. Elektrischer Schalter nach einem der Ansprüche 1 bis 4, **dadurch gekennzeichnet, dass** die Elektronik (11) einen Mikrocontroller aufweist, und dass eine Zeitspanne in der Art einer Abschaltzeit programmierbar ist, derart dass die Elektronik (11) bei Ablauf der Zeitspanne den Aktor (5) zum Schalten des Kontaktsystems (3) ansteuert.

6. Elektrischer Schalter nach einem der Ansprüche 1 bis 5, **dadurch gekennzeichnet, dass** die Netzfrequenz der Versorgungsspannung als Indikator zum Wechsel in den Testmodus verwendet wird, wobei wenn eine Netzfrequenz erkannt wird, die nicht den netzüblichen Frequenzen entspricht sowie einen definierten Wert aufweist, die Elektronik (11) in den Testmodus wechselt und wenn die Elektronik (11) anschließend eine netzübliche Frequenz erkennt, die Aktion des Testmodus aktiviert wird, wobei bei dieser Aktion der Schalter (1) vor Ablauf der Zeitspanne ausgeschaltet wird.

7. Elektrischer Schalter nach einem der Ansprüche 1 bis 6, **dadurch gekennzeichnet, dass** die Lasche (13) durch einen Schlitz im Gehäuse (2) nach außen geführt ist, und dass nach Entfernen des aus dem Gehäuseschlitz herausragenden Teils der Lasche (13) durch Abbrechen am Gehäuseschlitz die restliche Lasche (13) als Verschluss für den Gehäuseschlitz dient.

8. Elektrischer Schalter nach einem der Ansprüche 1 bis 7, **dadurch gekennzeichnet, dass** die Programmierlasche (13) durch einen Schlitz im Gehäuse (2) nach außen geführt ist.

9. Elektrischer Schalter nach einem der Ansprüche 1 bis 8, **dadurch gekennzeichnet, dass** die Programmierlasche (13) am Gehäuseaustritt perforiert ist, derart dass diese nach der Fertigstellung abgebrochen werden kann, wobei die restliche Programmierlasche (13) als Verschluss für den Gehäuseschlitz dient.

10. Elektrischer Schalter nach einem der Ansprüche 1 bis 9, **dadurch gekennzeichnet, dass** der Aktor (5) bei fehlerhaftem Nichterfolgen des Umschaltens des Kontaktsystems (3) in die andere Schaltstellung wenigstens ein weiteres Mal angesteuert wird.

11. Elektrischer Schalter nach einem der Ansprüche 1 bis 10, **dadurch gekennzeichnet, dass** zwischen den Ansteuerimpulsen (14) für den Aktor (5) eine an das Abkühlverhalten des Aktors (5) angepasste Zeit gewartet wird, bevor wieder der Steuerimpuls (14) für die nächste Ansteuerung ausgelöst wird, und dass nach einer definierten Anzahl an fehlerhaften Ansteuerversuchen die Funktion des ansteuerbaren Umschaltens deaktiviert wird.

12. Elektrischer Schalter nach einem der Ansprüche 1 bis 11, **dadurch gekennzeichnet, dass** der Lastkreis des Schalters (1) vom Ansteuerkreis des Aktors (5) getrennt ist, wobei der Ansteuerkreis mittels Niedervolt betrieben wird, und dass zur Trennung ein Opto-Koppler verwendet wird.

13. Elektrischer Schalter nach einem der Ansprüche 1 bis 12, **dadurch gekennzeichnet, dass** die Elektronik (11) eine Sicherung für den Überlastungs- und/oder Fehlerfall aufweist, und dass die Sicherung als eine Sicherungsstrecke im Leiterplattenlayout der Leiterplatte (12) integriert ist, wobei die Sicherungsstrecke in der Ebene und/oder räumlich in der Leiterplatte (12) geführt ist.

14. Elektrischer Schalter nach einem der Ansprüche 1 bis 13, **dadurch gekennzeichnet, dass** ein Mittel zur Messung des durch den Schalter (1) fließenden elektrischen Stroms vorgesehen ist, wobei das Mittel zur Strommessung einen Widerstand (15) umfasst.

15. Elektrischer Schalter nach Anspruch 14, **dadurch gekennzeichnet, dass** es sich bei dem Widerstand (15) um eine mäanderförmige Bahn an einem elektrischen Anschluss (10) des Schalters (1) handelt.

16. Elektrischer Schalter nach einem der Ansprüche 14 bis 15, **dadurch gekennzeichnet, dass** das Mittel zur Strommessung einen Verstärker (16) sowie einen Komparator (17) umfasst.

## Claims

1. An electrical switch having a contact system (3) and having a movable actuating member (4) for switching the contact system (3) between two switching positions and having a controllable actuator (5), which is in operative connection with the actuating member (4) such that the actuating member (4) in at least one of the two switching positions is moved into the other switching position when the actuator (5) is actuated for switching the contact system (3), wherein the actuator (5) is an electromagnet having a coil (6) and an armature (7), and wherein the operative connection between the actuator (5) and the actuating member (4) is effected by means of the armature (7), wherein the actuating member (4) is moved by the actuator (5) into the other switching position in that the armature (7) acts on a projection (9) on the actuating member (4) by means of a tappet (8),
wherein
the switch (1) has a housing (2), **characterised in that** the switch (1) has a printed circuit board (12) located in the housing (2), on which a programmable electronic unit (11) is located for the controlled movement of the actuating member (4) into the other switching position of the contact system (3), and that the circuit board (12) has a tab (13) through which the electronic unit (11) is operated in an operating mode, wherein by at least partially removing the tab (13) the electronic unit (11) is operated in a different operating mode, wherein the one operating mode is a test mode for checking the actuation of the actuator (5) and the test mode is terminated in the other operating mode,
and/or
the printed circuit board (12) has a programming tab (13) such that the programming and/or the final control of the switch (1) is made possible by contacting points on the programming tab (13).

2. The electrical switch according to claim 1, **characterised in that** the switching positions are a switch-on and a switch-off position, and **in that** the actuating member (4) is moved by the actuator (5) from the switch-on to the switch-off position of the contact system (3).

3. The electrical switch according to claim 1 or 2, **characterised in that** the actuator (5) is located in the housing (2).

4. The electrical switch according to claim 1, 2 or 3, **characterised in that** the programmable electronic unit (11) comprises a timer.

5. The electrical switch according to one of claims 1 to 4, **characterised in that** the electronic unit (11) comprises a microcontroller, and that a time period is programmable in the manner of a switch-off time such that the electronic unit (11) actuates the actuator (5) for switching the contact system (3) at the end of the time period.

6. The electrical switch according to one of claims 1 to 5, **characterised in that** the network frequency of the supply voltage is used as an indicator for switching to the test mode, wherein when a network frequency is detected which does not correspond to the common network frequencies and has a defined value, the electronic unit (11) switches to the test mode and when the electronic unit (11) subsequently detects a common network frequency, the operation of the test mode is activated, wherein the switch (1) is switched off before the end of the time period in the event of said operation.

7. The electrical switch according to one of claims 1 to 6, **characterised in that** the tab (13) is guided through a slot in the housing (2) to the outside, and that after removal of the part of the tab (13) protruding from the housing slot the rest of the tab (13) is used as a closure for the housing slot by breaking off in the housing slot.

8. The electrical switch according to any of claims 1 to 7, **characterised in that** the programming tab (13) is guided through a slot in the housing (2) to the outside.

9. The electrical switch according to one of claims 1 to 8, **characterised in that** the programming tab (13) is perforated at the housing outlet such that said programming tab can be broken off after completion, wherein the remaining programming tab (13) is used as a closure for the housing slot.

10. The electrical switch according to one of claims 1 to 9, **characterised in that** the actuator (5) is actuated at least once more in the event of a faulty failure of the contact system (3) to switch to the other switching position.

11. The electrical switch according to one of claims 1 to 10, **characterised in that** a time adapted to the cooling behaviour of the actuator (5) is waited for the actuator (5) between the actuation pulses (14) before the control pulse (14) is triggered again for the next actuation, and that after a defined number of faulty actuation attempts, the function of the actuatable switching is disabled.

12. The electrical switch according to one of claims 1 to 11, **characterised in that** the load circuit of the switch (1) is disconnected from the actuator circuit of the actuator (5), wherein the actuator circuit is operated by means of low voltage, and that an optocoupler is used for the disconnection.

13. The electrical switch according to one of claims 1 to 12, **characterised in that** the electronic unit (11) has a fuse in case of overload and/or failure, and that the fuse is integrated as a fuse section in the printed circuit board layout of the printed circuit board (12), wherein the fuse section is guided in the plane and/or spatially in the printed circuit board (12).

14. The electrical switch according to one of claims 1 to 13, **characterised in that** a means is provided for measuring the electrical current flowing through the switch (1), wherein the means for measuring the current comprises a resistor (15).

15. The electrical switch according to claim 14, **characterised in that** the resistor (15) is a meandering path on an electrical connection (10) of the switch (1).

16. The electrical switch according to one of claims 14 to 15, **characterised in that** the means for measuring the current comprises an amplifier (16) and a comparator (17).

## Revendications

1. Commutateur électrique comprenant un système de contact (3) et un organe d'actionnement (4) mobile destiné à faire basculer le système de contact (3) entre deux positions de commutation et comprenant un actionneur (5) pouvant être commandé et qui coopère avec l'organe d'actionnement (4), de sorte que l'organe d'actionnement (4), dans au moins une des deux positions de commutation, lorsque l'actionneur (5) est commandé pour faire basculer le système de contact (3), soit déplacé vers l'autre position de commutation, un électroaimant présentant une bobine (6) et une armature (7) étant utilisé comme actionneur (5) et la coopération entre l'actionneur (5) et l'organe d'actionnement (4) étant réalisée au moyen de l'armature (7), l'organe d'actionnement (4) étant déplacé par l'actionneur (5) dans l'autre position de commutation, en ce que l'armature (7) agit sur une saillie (9) de l'organe d'actionnement (4) au moyen d'un plongeur (8),
dans lequel
le commutateur (1) présente un boîtier (2), **caractérisé en ce que** le commutateur (1) présente une carte de circuit imprimé (12) située dans le boîtier (2), sur laquelle se trouve un système électronique programmable (11), afin d'effectuer le mouvement contrôlé de l'organe d'actionnement (4) dans l'autre position de commutation du système de contact (3) et **en ce que** la carte de circuit imprimé (12) présente une patte (13) au moyen de laquelle le système électronique (11) est actionné dans un mode de fonctionnement, par éloignement au moins partiel de la patte (13), le système électronique (11) étant actionné dans un mode de fonctionnement différent, le premier mode de fonctionnement étant un mode de test pour contrôler la commande de l'actionneur (5) et le mode de test étant achevé dans l'autre mode de fonctionnement,
et/ou
la carte de circuit imprimé (12) présente une patte de programmation (13) telle que la programmation et/ou la commande finale du commutateur (1) est rendue possible par des points de contact situés sur la patte de programmation (13).

2. Commutateur électrique selon la revendication 1, **caractérisé en ce que** les positions de commutation sont une position d'activation et une position de désactivation et **en ce que** l'organe d'actionnement (4) est déplacé depuis l'actionneur (5) de la position d'activation à la position de désactivation du système de contact (3).

3. Commutateur électrique selon la revendication 1 ou 2, **caractérisé en ce que** l'actionneur (5) est disposé dans le boîtier (2).

4. Commutateur électrique selon la revendication 1, 2 ou 3, **caractérisé en ce que** le système électronique programmable (11) comprend une minuterie.

5. Commutateur électrique selon l'une quelconque des revendications 1 à 4, **caractérisé en ce que** le système électronique (11) comprend un microcontrôleur et **en ce qu'**une période est programmable sous forme de temps d'arrêt, de sorte que le système électronique (11) à la fin de la période, commande l'actionneur (5) pour commuter le système de contact (3).

6. Commutateur électrique selon l'une quelconque des revendications 1 à 5, **caractérisé en ce que** la fréquence du réseau de la tension d'alimentation sert d'indicateur pour le passage au mode de test, dans lequel, lorsqu'une fréquence de réseau est détectée, qui ne correspond pas aux fréquences de réseau habituelles et a une valeur définie, le système électronique (11) passe en mode de test et lorsque le système électronique (11) détecte ensuite une fréquence de réseau habituelle, l'action du mode de test est activée, lors de cette action, le commutateur (1) étant désactivé avant l'expiration de la période.

7. Commutateur électrique selon l'une quelconque des revendications 1 à 6, **caractérisé en ce que** la patte (13) est guidée vers l'extérieur à travers une fente du boîtier (2) et **en ce qu'**après éloignement de la partie en saillie de la patte (13) par rupture au niveau de la fente du boîtier, le reste de la patte (13) sert de fermeture pour la fente du boîtier.

8. Commutateur électrique selon l'une quelconque des revendications 1 à 7, **caractérisé en ce que** la patte de programmation (13) est guidée vers l'extérieur à travers une fente dans le boîtier (2).

9. Commutateur électrique selon l'une quelconque des revendications 1 à 8, **caractérisé en ce que** la patte de programmation (13) est perforée à la sortie du boîtier, de manière à pouvoir être rompue après l'achèvement, le reste de la patte de programmation (13) servant de fermeture pour la fente du boîtier.

10. Commutateur électrique selon l'une quelconque des revendications 1 à 9, **caractérisé en ce que** l'actionneur (5) est commandé au moins une fois supplémentaire en cas d'échec de la commutation du système de contact (3) dans l'autre position de commutation.

11. Commutateur électrique selon l'une quelconque des revendications 1 à 10, **caractérisé en ce qu'**un temps adapté au comportement de refroidissement de l'actionneur (5) est attendu entre les impulsions de commande (14) pour l'actionneur (5) avant que l'impulsion de commande (14) pour la commande suivante ne soit déclenchée et **en ce qu'**après un nombre défini de tentatives de commande défectueuses, la fonction de commutation contrôlable est désactivée.

12. Commutateur électrique selon l'une quelconque des revendications 1 à 11, **caractérisé en ce que** le circuit de charge du commutateur (1) est séparé du circuit de commande de l'actionneur (5), le circuit de commande fonctionnant au moyen d'une basse tension et **en ce qu'**un coupleur optique est utilisé pour la séparation.

13. Commutateur électrique selon l'une quelconque des revendications 1 à 12, **caractérisé en ce que** le système électronique (11) comporte un fusible pour la surcharge et/ou la défaillance et **en ce que** le fusible est intégré en tant que segment de fusible dans l'agencement de carte de la carte de circuit imprimé (12), le segment de fusible étant guidé dans le plan et/ou spatialement dans la carte de circuit imprimé (12).

14. Commutateur électrique selon l'une quelconque des revendications 1 à 13, **caractérisé en ce qu'**il est prévu un moyen de mesure du courant électrique traversant le commutateur (1), le moyen de mesure du courant comprenant une résistance (15).

15. Commutateur électrique selon la revendication 14, **caractérisé en ce que** la résistance (15) est une piste sinueuse sur une connexion électrique (10) du commutateur (1).

16. Commutateur électrique selon l'une quelconque des revendications 14 à 15, **caractérisé en ce que** le moyen de mesure du courant comprend un amplificateur (16) et un comparateur (17).
